(19) Europäisches Patentamt
European Patent Office
Office européen des brevets

(11) EP 4 535 690 A1

(12) **EUROPEAN PATENT APPLICATION**

(43) Date of publication:
**09.04.2025 Bulletin 2025/15**

(21) Application number: **24194913.0**

(22) Date of filing: **16.08.2024**

(51) International Patent Classification (IPC):
**H04B 10/70** *(2013.01)* **H01S 5/00** *(2006.01)*
**H01S 5/062** *(2006.01)* **H01S 5/40** *(2006.01)*

(52) Cooperative Patent Classification (CPC):
**H01S 5/0064; H01S 5/06216; H01S 5/06236;
H01S 5/4006; H04B 10/70**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **06.10.2023 GB 202315329**

(71) Applicant: **Kabushiki Kaisha Toshiba
Minato-ku
Tokyo (JP)**

(72) Inventors:
• **WOODWARD, Robert Ian**
  **Cambridge, CB4 0GZ (GB)**
• **ROGER, Thomas**
  **Cambridge, CB4 0GZ (GB)**
• **SHIELDS, Andrew James**
  **Cambridge, CB4 0GZ (GB)**

(74) Representative: **Marks & Clerk LLP
15 Fetter Lane
London EC4A 1BW (GB)**

(54) **OPTICAL INJECTION LOCKING APPARATUS**

(57) A laser injection locking apparatus comprising a primary laser configured to emit light of a first polarisation, a secondary laser configured to be injected by light from the primary laser, the secondary laser being connected to the primary laser by an optical path, and a phase retarder provided in the optical path between the primary laser and the secondary laser. The phase retarder is configured to convert light of the first polarisation to light of a second polarisation. The first polarisation either linear or circular, and the second polarisation is the other.

400

402
410
406
404
408

FIG. 4

## Description

FIELD OF THE INVENTION

Embodiments described herein generally relate to techniques for optical injection locking.

BACKGROUND TO THE INVENTION

Optical injection locking is a widely used technique in laser systems, in fields including quantum communication. Optical injection locking generally involves a primary laser and secondary laser. For example, light from the primary laser may be used to define the phase between pulses output by the secondary laser.

BRIEF DESCRIPTION OF THE DRAWINGS

Fig. 1 shows a Faraday isolator;
Figs. 2A is a sketch of an apparatus for optical injection locking;
Figs. 2B-2D illustrate the behaviour of the apparatus of Fig. 2A;
Fig. 3A is a block diagram of an apparatus for optical injection locking;
Fig. 3B illustrates the behaviour of the apparatus of Fig. 3B;
Fig. 4 shows an optical injection locking apparatus in accordance with an embodiment;
Figs. 5 and 6 show further optical injection locking apparatuses in accordance with further embodiments;
Fig. 7 is a flow chart illustrating a method of optical injection locking in accordance with an embodiment; and
Fig. 8A and 8B respectively show a transmitter and a receiver of a quantum key distribution (QKD) system.

DETAILED DESCRIPTION

In an embodiment, a laser injection locking apparatus is provided, the apparatus comprising:

a primary laser configured to emit light of a first polarisation;
a secondary laser configured to be injected by light from the primary laser, the secondary laser being connected to the primary laser by an optical path; and
a phase retarder provided in the optical path between the primary laser and the secondary laser, the phase retarder configured to convert light of the first polarisation to light of a second polarisation, wherein the first polarisation is one of linear polarisation and circular polarisation, and the second polarisation is the other.

The above apparatus allows the mitigation of the effects of back-reflections, e.g. by the suppression of back-reflection-related laser disturbance. In injection-locked systems, as in many other optical systems, it is desirable to prevent back-reflections. For example, a portion of light emitted by the primary laser may be back-reflected at an input of the secondary laser. If this light re-enters the primary laser it may interfere with the primary laser's operation, which may for example disrupt the desired phase relation between pulses.

Anti-reflection coatings may be used in such systems. However, it is noted that the input of the secondary laser cannot be entirely anti-reflective, as the secondary laser must form a reflective cavity in order to operate as a laser, and so anti-reflective coatings cannot be entirely effective in this instance.

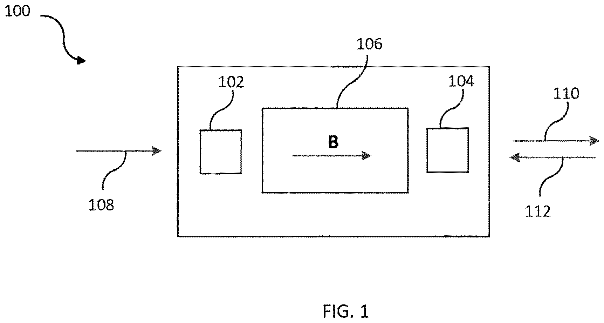

Fig. 1 shows the use of a Faraday isolator 100 for blocking back-reflections. For example, such an isolator 100 may be inserted between the primary and secondary lasers of an optical injection locking apparatus. A Faraday isolator 100 comprises two polarisers 102 and 104 on either side of a Faraday rotator 106. Incident light 108 is polarised by the first polariser 102 to have a particular linear polarisation (for example, horizontal), and then passes through the Faraday rotator 106 whereupon the polarisation is rotated by 45°. The second polariser 104 is oriented to transmit this diagonal light 110 out of the Faraday isolator 100. Back-reflected light 112 having the same diagonal polarisation may re-enter the Faraday isolator 100 by passing through the second polariser 104. Passing back through the Faraday rotator 106, the polarisation of the back-reflected light will be rotated by a further 45° resulting in a vertical polarisation. Since the first polariser 102 is oriented to transmit horizontal light, the vertical back-reflected light will be rejected by the first polariser 102 and cannot pass back out of the Faraday isolator 100. In this manner the Faraday isolator 100 prevents back-reflections from returning to any optical components earlier in the beam path.

The Faraday isolator 100 depends on non-reciprocal rotation by the Faraday rotator 106. This is achieved using a strong permanent magnetic field B within the Faraday rotator 106, as shown in Fig. 1.

It is noted that, owing to the presence of polarisers 102 and 104, the Faraday isolator operates regardless of the polarisation of incoming light 108, 112 from either direction, as the light is first polarised by the respective polariser 102, 104.

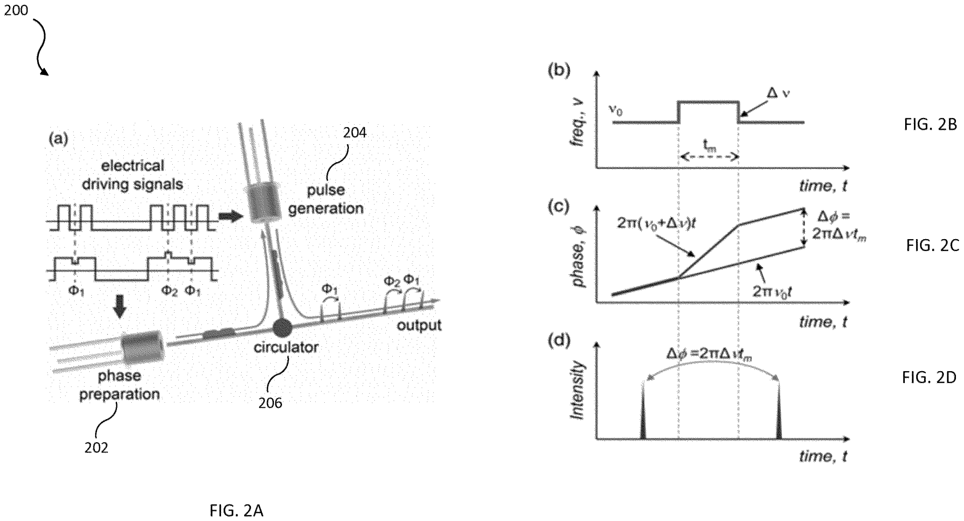

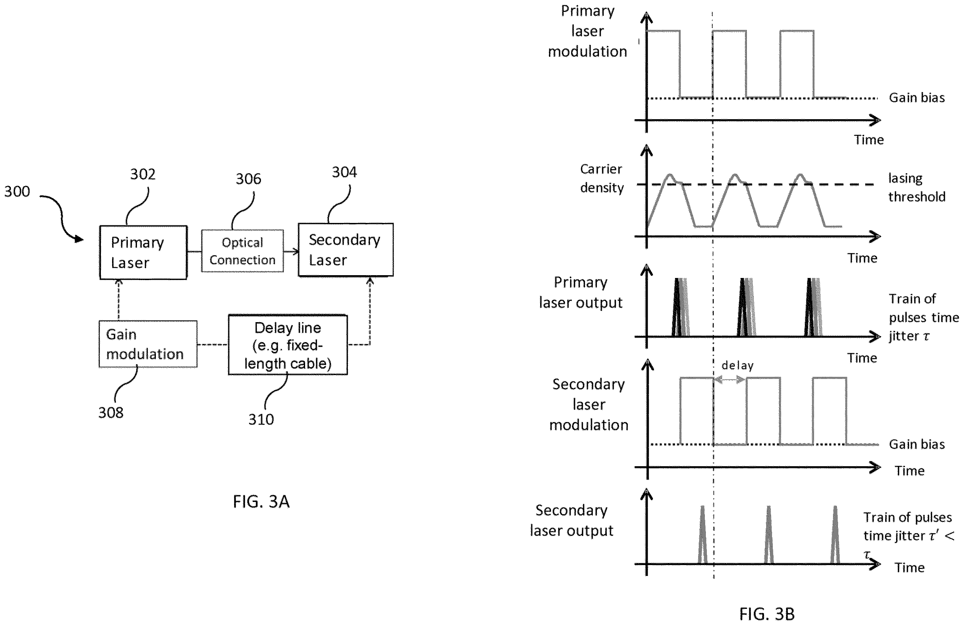

Figs. 2A to 2D and 3A and 3B will now be used to explain a specific type of source which allows the formation of an ultra-compact and high-performance quantum key distribution (QKD) transmitter. This source 200, shown in FIG. 2A, has directly phase modulated pulses using gain-switching and optical injection locking and does not need external phase modulators.

The source 200 comprises a pulsed secondary laser 204 into which a pulse from a primary laser 202 is injected to define the phase between the secondary laser's output pulses, based on *optical injection locking.* The primary laser 202 performs the task of phase preparation whereas the secondary laser 204 performs the task of pulse preparation. The description of FIGS. 2A to 2D focusses more on the control of the primary laser. The description of FIGS. 3A and 3B focusses more on the secondary laser and the combination of the two lasers.

As schematically depicted in FIG. 2A, a primary laser diode 202 is connected to a secondary laser diode 204 via an optical circulator 206. It should be noted that the primary 202 and secondary 204 laser diodes may be identical, the terms "primary" and "secondary" are used merely for clarity and do not imply any physical differences between the primary 202 and secondary 204 laser diodes.

The primary laser 202 is used for phase preparation, and is directly modulated to produce long pulses from quasi-steady-state emission. Each of these pulses coherently seeds a block of two or more secondary, short optical pulses emitted by gain switching the secondary or pulse-generation laser 204. The phase-preparation laser 202 is biased to produce nanosecond scale or even less, quasi-steady-state optical pulses with shallow intensity modulation, which also modifies the optical phase. For clock rates greater than 1 GHz, the pulse width is less than 1 ns. The gain-switched pulse-generation laser 202 emits short optical pulses which inherit the optical phase prepared by the phase-preparation laser. The duration of each phase-preparation laser pulse can be varied to seed a pulse train of different lengths.

The relative phase between the secondary pulses depends on the phase evolution of the primary pulses and can be set to an arbitrary value by directly modulating the driving current applied to the primary or phase-preparation laser 202.

For example, a relative phase $\phi_1$ between two secondary pulses can be obtained by introducing a small perturbation in the driving signal of the phase-preparation laser 202. Similarly, the relative phases between three secondary pulses can be set to $\phi_1$ and $\phi_2$ by adding two small perturbations to the driving signal of the primary laser 202.

In principle, such perturbations in the driving signal would cause detrimental fluctuations in the intensity and frequency of the primary pulses. However, these can be avoided by switching the secondary laser's 204 gain off in correspondence with the perturbation signals. Effectively, the secondary laser 204 also acts as a filter rejecting residual modulations.

To understand how an optical phase is set by perturbing the driving signal applied to the phase-preparation laser, it is useful to consider a continuous wave (CW) laser above threshold emitting at the central frequency $v_0$.

FIG. 2B is a plot of the optical frequency of the phase-preparation laser 202 under a small perturbation of duration $t_m$. FIG. 2C is a plot of optical phase trajectories with and without the perturbation of the phase-preparation laser 202.

When a small perturbation is applied to the driving signal, the optical frequency shifts by an amount $\Delta v$, changing the course of the phase evolution. When the perturbation is switched off, the frequency is restored to the initial value $v_0$. This perturbation will create a phase difference:

$$\Delta\phi = 2\pi\Delta v t_m$$

where $t_m$ is the duration of the perturbation. Through optical injection, this phase difference is transferred onto a pair of secondary pulses emitted by the pulse-generation laser 204 as shown in FIG. 2D.

The perturbation signal here is an electrical voltage modulation applied to the phase-preparation laser 202. The optical frequency change arises from the effect of the carrier density on the refractive index in the laser active medium within the primary laser diode 202. The laser cavity confinement allows the light field to oscillate back and forth within the cavity and experience the refractive-index change for the entire duration of the perturbation. The enhancement due to the laser cavity makes it possible to keep the phase modulation half-wave voltage below 1 V, as we demonstrate later. This cavity feature is absent in conventional phase modulators, where the light makes just a single pass across the electro-optic medium, thus limiting the interaction distance to the device length.

Small changes to the primary laser's 202 electric controller signal (for example, of less than 1 volt - much less than required by a conventional lithium niobite phase modulator) can yield transient changes to the output frequency of the primary laser's 202 output, which then change the output phase of the secondary laser's 204 optical output.

In this embodiment, the primary laser 202 is configured to output a sequence of light pulses comprising a sequence of pairs. The phase of the pulses output by the primary laser 202 is controlled so that the phase between pulses in the same pair is randomly selected from one of a set of phase differences and there is a random phase difference between pulses from different pairs. In an embodiment, the set of phase differences may be selected from one of 0, $\pi/2$, $-\pi/2$ and $\pi$.

The secondary laser 204 that is seeded by the primary laser 202 will output a sequence of pairs of pulses having the same phase differences as the sequence of pulses output by the primary laser 202.

Pulsed injection seeding occurs each time the secondary laser 204 is switched above the lasing threshold. In this case, the generated secondary light pulse has a fixed phase relation to the injected primary light pulse. As only one secondary light pulse is generated for each injected primary light pulse, the phase relationship between the pulses output by the secondary laser 204 is the same as the relationship between the pulses injected into the secondary laser 204.

Under the operating conditions that will be described below in relation to Fig. 3, the secondary laser 204 generates a new sequence of pulses, which comprise a sequence of pairs. The phase between pulses in the same pair is randomly selected from one of a set of phase differences and there is a random phase difference between pulses from different pairs. These pulses will also have a smaller time jitter $\tau' < \tau$ to the pulses outputted by the primary laser 202. The reduced jitter time thus improves interference visibility due to the low time jitter of the secondary light pulses.

In order for pulsed injection seeding to occur, the frequency of the light pulses from the primary laser 202 must match the frequency of the secondary laser 204 to within a certain range. In one embodiment, the difference in the frequency of the light supplied by the primary laser 202 and the frequency of the secondary laser 204 is less than 30GHz. In some embodiments, where the secondary laser 204 is a distributed feedback (DFB) laser diode the frequency difference is less than 100GHz.

For successful pulsed injection seeding the relative power of the primary laser 202 output light pulses that enter the optical cavity of the secondary laser 204 has to be within certain limits which depend on the type of light source that is used. In one embodiment, the optical power of the injected light pulses is at least 1000 times lower than the optical output power of the secondary laser 204. In one embodiment, the optical power of the injected light pulses is at least 100 times lower than the optical output power of the secondary laser 204.

In one embodiment, secondary laser 204 and primary laser 202 are electrically driven, gain-switched semiconductor laser diodes. In one embodiment, the secondary laser 204 and primary laser 202 have the same bandwidth. In one embodiment, both lasers 202, 204 have a bandwidth of 10 GHz. In one embodiment, both lasers 202, 204 have a bandwidth of 2.5 GHz. Here, the bandwidth means the highest bit rate achievable with the gain-switched laser diode under direct modulation. A laser of a certain bandwidth can be operated at a lower clock rate.

FIG. 3A is a schematic illustration of a driving scheme for the phase-randomised light source 300 for which both the primary laser 302 and the secondary laser 304 are driven with a single gain modulation unit 308. The gain modulation unit 308 and delay line 310 are an example of a controller which is configured to apply a time varying drive signal to the secondary laser 304 such that just one light pulse is generated during each period of time for which a light pulse is received. The primary laser 302 is connected to the secondary laser 304 via an optical connection 306. The optical connection 306 could be a waveguide, for example an optical fibre. Alternatively, the light pulses may travel between the primary laser 302 and the secondary laser 304 through free space. The optical connection may include further components such as an optical circulator or a beam splitter as provided in the arrangement of FIG. 2A.

A gain modulation unit 308 drives both the primary laser 302 and the secondary laser 304 to generate pulses of light. The delay line 310 is used to synchronise the apparatus. The delay line may be, for example, a fixed length cable. The gain modulation unit is directly connected to the primary laser 302. For example, where the primary laser 302 is a semiconductor laser, a gain modulation circuit is electrically connected to the primary laser 302. The gain modulation unit 308 is connected to the secondary laser 304 through the delay line 310.

FIG. 3B shows a temporal sequence for the single gain modulation scheme 300 shown in FIG. 3A. The upper graph shows the gain modulation applied to the primary laser 302. The current applied to the laser is shown on the vertical axis, with time on the horizontal axis. The gain modulation is a time varying drive signal, having the form of a square wave, which when applied to the primary laser 302, increases the carrier density above and below the lasing threshold. In other words, the gain modulation is a series of pulses. In between the pulses, the gain has a minimum value, which is the gain bias and is indicated by the dotted line. The wave in this case is a square-type waveform. A different gain modulation signal can be used, for example a sine wave, or a non-periodic time varying signal. In this case, the current is not reduced to zero in between the current modulation pulses, but only reduced to a bias value (which is indicated by the dotted line).

The current modulation signal is applied to the laser and switches the gain of the laser above and below the lasing threshold periodically. The second graph shows the carrier density of the laser on the vertical axis, against time on the horizontal axis. The lasing threshold is indicated by a dashed horizontal line. When a current modulation pulse is applied to the laser, the injected carriers increase the carrier density and the photon density increases.

The laser output generated by the modulation signal is shown in the lower graph. The vertical axis shows the laser intensity, with time on the horizontal axis. The laser outputs light when the carrier density is above the lasing threshold. Photons generated by spontaneous emission inside the laser cavity are amplified sufficiently by stimulated emission to generate an output signal. The length of the delay between the application of the current modulation pulse and the generation of the output light depends on several parameters, such as the laser type, cavity length and pumping power.

The rapid increase of the photon density causes a decrease in the carrier density. This in turn decreases the photon density, which increases the carrier density. At this point the current modulation pulse is timed to switch back down to the DC bias level, and the laser emission dies off quickly. The laser output therefore consists of a train of short laser pulses as shown in the lower graph.

To generate longer pulses, the gain bias is chosen to be closer to the lasing threshold. This means that the carrier density crosses the lasing threshold earlier, which gives the light pulse more time to evolve. Initially the light intensity will overshoot and quickly reduce the carrier density. This in turn causes the photon density to decrease and the carrier density to increase, in turn increasing the light intensity. This competing process causes oscillations of the light intensity at the beginning of the pulse which are strongly damped, leading quickly to a steady-state where the intensity is constant. The oscillations are called relaxation oscillations. The laser pulse ends when the current pulse ends and switches the current to the bias value again.

The next graph shows the output of the primary laser 302. One light pulse is outputted each time the carrier density increases above the lasing threshold. As explained above, there can be a delay between when the gain increases and when a light pulse is outputted. The light pulses output from the primary laser 302 have a large time jitter $\tau$.

The next graph shows the gain modulation applied to the secondary laser 304. The gain modulation is the same as that applied to the primary laser 302, with the addition of the time delay labelled by an arrow. The gain modulation is a time varying drive signal applied to the secondary laser. In other words, the gain modulation applied to the secondary laser. 304 is shifted in time with respect to the gain modulation applied to the primary laser 302. Each periodic increase in gain is applied to the secondary laser 304 later than it is applied to the primary laser 302. The delay in this case is around half a period of the gain modulation signal. The delay means that the periodic increase in gain is applied to the secondary laser 304 after the light pulse has been injected. Therefore the light pulse from the primary laser 302 is present in the laser cavity of the secondary laser 304 when the gain increase is applied, resulting in the secondary laser 304 generating a light pulse by stimulated emission from the primary light pulse. This means that the generated light pulses from the secondary laser 304 have a fixed phase relation to the light pulses injected into the secondary laser 304 from the primary laser 302.

The secondary laser 304 is switched above the lasing threshold after a light pulse from the primary laser 302 has been injected such that a pulse from the secondary laser 304 is initiated by stimulated emission caused by the injected light pulse. The timing of the onset of the gain bias of the secondary laser 304 is controlled via the delay line 310. The final graph shows the output of the secondary laser 304. Only one light pulse is outputted each time the carrier density increases above the lasing threshold. Again, there can be a delay between the increase in gain modulation and the outputted light pulse. The time jitter of the outputted light pulses from the secondary laser 304 is lower than that of the jitter of the light pulses from the primary laser 302.

In the system shown in FIG. 3A, the gain modulation unit 308 applies a time varying gain modulation to the secondary laser 304 such that it is switched above the lasing threshold only once during the time that each light pulse from the primary laser 302 is incident. The switching of the secondary laser 304 is synchronised with the arrival of the light pulses from the primary laser 302 because the same gain modulation signal is applied to both light sources, and a delay line 310 delays the application of the increase in gain to the secondary laser 304 with respect to the primary laser 302.

In the system shown in FIG. 3B the time varying gain modulation signal hecas a square type wave form. However, the time varying gain modulation can comprise signals with arbitrary pulse shape.

Where the light sources are gain-switched semiconductor lasers, the gain modulation signal is an applied current or voltage. In one embodiment, the gain modulation signal is an applied current or voltage with a square type wave form. In an alternative embodiment, the time varying current or voltage is an electrical sine wave generated by a frequency synthesizer. In one embodiment, the frequency of the gain modulation signal is less than or equal to 4 GHz. In one embodiment, the frequency is 2.5 GHz. In one embodiment, the frequency is 2 GHz.

A gain-switched semiconductor laser has a good extinction ratio between the state when pulses are emitted and the "off" state. It can be used to generate very short pulses. In one embodiment, the duration of each of the pulses output from the secondary laser 304 is less than 200ps. In one embodiment, the duration of each of the pulses output from the secondary laser 304 is less than 50ps. In one embodiment, the duration of each of the pulses output from the secondary laser 304 is of the order of a few picoseconds. In one embodiment, where the time varying current or voltage is a square wave current or voltage with a frequency of 2 GHz, the short light pulses are 500 ps apart.

In the light source 300 shown in these figures, the primary laser 302 and the secondary laser 304 share the same electrical driver for gain modulation. However, the primary laser 302 and the secondary laser 304 could also be driven by separate gain modulation units 308. By driving the gain modulation by separate units, it is possible to generate longer light pulses output from the primary laser 302 than those shown in FIG. 3B as the gain bias value is closer to the lasing threshold. This means that the carrier density crosses the lasing threshold earlier, which gives the light pulse more time to evolve. This can also be used to reduce jitter.

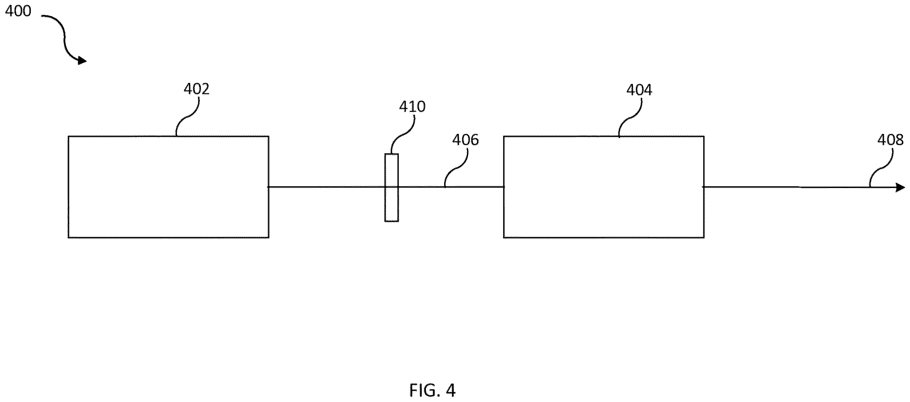

Fig. 4 shows a laser injection locking apparatus in accordance with an embodiment.

As described in more detail below with regard to Fig. 4, this configuration mitigates back-reflections using only a phase retarder, without the need for a bulkier and more expensive Faraday isolator.

Additionally, it is noted that the Faraday effect is strongly wavelength-dependent via the Verdet constant, such that Faraday isolators provide adequate isolation only within a fairly narrow wavelength range. Indeed, over some wavelength ranges (e.g. the mid-infrared) materials with an appropriate Verdet constant are not available, such that Faraday isolators cannot be produced at all. By contrast, widely available phase retarders, such as quarter waveplates (especially achromatic quarter waveplates) and Fresnel rhombs, may operate over significantly wider spectral ranges.

Further, Faraday isolators require a strong B field to realise the Faraday effect (for example, many commercial Faraday isolators contain a strong permanent magnet). This is inconvenient for anyone working nearby with metal components and/or tools, and in some applications may interfere with other equipment in use nearby. Additionally, magnets generally cannot be miniaturised, resulting in optical isolators tend to be relatively large and bulky. Magnets also cannot be included in photonic integration schemes, so chip-based technologies that require magnets are generally not possible. By contrast, common phase retarders do not use a B field.

In an embodiment, the secondary laser comprises an input operable to reflect a portion of the light of the second polarisation arriving at the secondary laser; and the phase retarder is positioned such that light back-reflected along the optical path by the input passes through the phase retarder a second time and is converted to light of a third polarisation orthogonal to the first polarisation.

In this embodiment, back-reflected light re-entering the primary laser is not of the correct polarisation to interfere with the primary laser's operation. For example, if the first polarisation is e.g. horizontal, back-reflected light re-entering the primary laser will be vertical. If the primary laser has a fixed polarisation, such as e.g. a semiconductor laser, this vertically-polarised light will not be significantly amplified by the primary laser's optical cavity.

In an embodiment, the first polarisation is a linear polarisation, the phase retarder comprises a quarter waveplate, and an axis of the quarter waveplate is aligned at 45° to the first polarisation.

Quarter waveplates are widely-available components that are cheaper and smaller than a Faraday isolator. The alignment of the quarter waveplate at 45° to the first polarisation ensures conversion of the linear polarisation to circular.

In an embodiment, the quarter waveplate is an achromatic quarter waveplate.

This allows effective operation over a wider range of wavelengths.

In an embodiment, the phase retarder comprises a Fresnel rhomb.

Fresnel rhombs achieve a polarisation shift that is particularly insensitive to wavelength. Thus, this embodiment can increase the range of wavelengths at which the apparatus can effectively operate,

In an embodiment, the apparatus further comprises a polariser positioned between the primary laser and the phase retarder, the polariser configured to transmit light of the first polarisation.

This allows the deflection of back-reflected light of the third polarisation so that it does not reach the primary laser.

In an embodiment, the primary laser and the secondary laser are configured to operate as pulsed lasers.

In an embodiment, at least one of the primary laser and the secondary laser is configured to operate using gain-switching.

This allows very high pulse rates (as high as GHz) to be used with a randomised pulse of each phase. Gain-switched laser systems are often extremely reliant on the prevention of back-reflections, so the present invention is particularly advantageous.

In an embodiment, at least one of the primary laser and the secondary laser is a tuneable laser.

This allows wideband operation, potentially over a wavelength range of 100 nm or more. In further embodiments, this is used when the phase retarder is an achromatic quarter waveplate or a Fresnel rhomb.

In an embodiment, a polarisation extinction ratio of light emitted by the primary laser is at least 20dB in favour of the first polarisation.

Thus, if the primary laser operates predominantly in a single linear polarisation, back-reflections of the orthogonal linear polarisation will not interfere with the primary laser's operation.

In an embodiment, the apparatus further comprises a secondary phase retarder in the optical path after the secondary laser, wherein the secondary phase retarder is configured to convert light of the first polarisation to light of the second polarisation.

This mitigates back-reflections from any components that may be positioned after the secondary laser, thereby preventing destabilisation of the secondary laser.

In an embodiment, the apparatus further comprising a secondary polariser in the optical path between the secondary laser and the secondary phase retarder, wherein the secondary polariser is configured to transmit light of the first polarisation.

This prevents back-reflections that have passed through the secondary phase retarder from reaching the secondary laser, as they will be of an orthogonal polarisation to the first polarisation and will consequently be rejected by the second polariser.

In an embodiment, the optical path is a fibre path.

All-fibre assemblies are generally more compact and robust than assemblies using free-space transmission.

In an embodiment, the phase retarder comprises a strained portion of optical fibre.

This can allow quarter waveplate-type behaviour in an all-fibre assembly.

In a further embodiment there is provided a packaged micro-optic assembly comprising the apparatus described above.

This embodiment provides an extremely compact optical injection locking apparatus that nonetheless mitigates back-reflection. It is noted that such a micro-optic assembly cannot contain a Faraday isolator, as they are too big, and so the ability to provide a micro-optic assembly is specific to the present invention.

In a further embodiment there is provided a quantum cryptographic system comprising an emitter and a receiver, the emitter comprising the apparatus described above.

This embodiment provides a quantum cryptographic system with a high degree of stability and reliability, since back-reflections will not destabilise the primary laser of the emitter, without needing to use a Faraday isolator. This in turn allows the quantum cryptographic system to be more compact, and to operate over a wider range of wavelengths, as described herein.

In a further embodiment there is provided a method of laser injection locking, the method comprising: receiving light from a primary laser, the light comprising a first polarisation; converting the light of the first polarisation into light of a second polarisation; and transmitting the light of the second polarisation onto a secondary laser to inject the secondary laser, wherein the first polarisation is one of linear polarisation and circular polarisation, and the second polarisation is the other.

This allows the mitigation of back-reflections (as described below with regard to Fig. 2) without the need for a Faraday isolator, using instead merely a shift in polarisation that can be accomplished with simpler components.

In an embodiment, the converting the light of the first polarisation into light of the second polarisation is performed using a phase retarder.

This has the advantage that phase retarders are generally smaller, cheaper, less wavelength-dependent, and available at more operating wavelengths than Faraday isolators.

In an embodiment, the method further comprises: receiving back-reflected light from an input of the secondary laser; converting the back-reflected light into light of a third polarisation, the third polarisation being orthogonal to the first polarisation; and transmitting the light of the third polarisation onto the primary laser.

This means that back-reflected light re-entering the primary laser is not of the correct polarisation to interfere with the primary laser's operation. For example, if the first polarisation is e.g. horizontal, back-reflected light re-entering the primary laser will be vertical. If the primary laser has a fixed polarisation, such as e.g. a semiconductor laser, this vertically-polarised light will not be significantly amplified by the primary laser's optical cavity.

In an embodiment, the converting the back-reflected light into light of the third polarisation is performed using the phase retarder.

This embodiment provides a compact and simple optical injection locking apparatus that nonetheless achieves the goal of mitigating back-reflections.

Fig. 4 shows an optical injection locking apparatus 400 according to an embodiment of the present disclosure. The apparatus 400 comprises a primary laser 402 and a secondary laser 404, with an optical path provided in between the two lasers 402, 404. A phase retarder 410 is provided in the optical path. While no other components are shown in Fig. 4, it is noted that the phase retarder 410 need not be the only optical component in between the two lasers, and in embodiments other components may be present as well.

When the apparatus of Fig. 4 is in operation, the primary laser 402 emits light 406 that is used to inject the secondary laser 404. The secondary laser then emits its own light 408. The phase retarder 410 is provided in between the primary laser 402 and secondary laser 404 such that the light 406 passes through the phase retarder 410.

We now describe how the apparatus in Fig. 4 mitigates the effect of back-reflections.

For ease of discussion, let us assume that the primary laser 402 emits linearly polarised light 406. It will be appreciated that the following discussion applies *mutatis mutandis* to the case where the primary laser 402 instead emits circularly polarised light 406. We further note that references to the primary laser 402 emitting linearly polarised light do not necessarily imply that the light is entirely of uniform polarisation; in real systems there may well be components of one or more other polarisations present as well. It may be that one polarisation heavily dominates; for example, there may be a polarisation extinction ratio of 20dB or more in favour of the "main" polarisation.

The phase retarder 410 is configured to convert the linear polarisation of the light 406 to circular polarisation. In embodiments where the phase retarder 410 is a quarter waveplate, this may be achieved by positioning the axes of the quarter waveplate at 45° to the plane of polarisation of the light 406, such that a $\pi/2$ phase shift is introduced between the components of the electric field of the light 406 parallel to each axis.

Circularly polarised light can be considered as a mixture of two orthogonal linear polarisations with a relative phase of $\pi/2$. If the secondary laser 404 is a laser that lases with a fixed linear polarisation - for example, a semiconductor laser - only one of the two linear components of the circularly polarised light 406 will be significantly amplified by the secondary laser 404, with the other linear component having essentially no effect on the secondary laser 404. The secondary laser 404 may therefore be injection locked just as effectively by circularly polarised light as by linearly polarised light.

In embodiments, some of the circularly polarised light 406 may be back-reflected at an input (e.g. an entrance facet) of the secondary laser 404. It is well known that reflecting a wave results in a phase shift of $\pi$, and an accompanying change of handedness of circularly polarised light. For example, if the light 406 is left circularly polarised after the phase retarder 410, it will be right circularly polarised after being back-reflected.

As a result of this phase shift upon reflection, the back-reflected light, upon reaching the phase retarder 410, will be converted into linearly polarised light with the *orthogonal* linear polarisation to that emitted by the primary laser 402. For example, if the primary laser 402 emits horizontal light, any back-reflected light that arrives back at the primary laser (having passed through the phase retarder 410 twice and been reflected) will be vertically polarised.

As a result, if the primary laser 402 is a laser that lases with a fixed linear polarisation (such as a semiconductor laser), these back-reflections re-entering the primary laser 402 will be of the wrong polarisation to be amplified, and will not significantly impact on the operation of the primary laser 402.

In this way the phase retarder 410 mitigates the effect of back-reflections and allows the primary laser 402 to operate without e.g. loss of phase coherency.

It is noted that, unlike the Faraday isolator described above with regard to Fig. 1, this method does not work regardless of the polarisation of the light 406 (or of the back-reflected light). Rather, the light 406 emitted by the primary laser 402 must have a known dominant polarisation and the phase retarder 410 must be aligned to account for this polarisation; additionally, the polarisation of back-reflected light must have a predictable relation to the polarisation of the light 406. In particular, the reason why the non-reciprocity of a B field is not required (as it is for the Faraday isolator) is the $\pi$ phase shift on back-reflection, and the accompanying change in handedness of circularly polarised light. This allows the avoidance of inconvenience and potential interference with other components that may arise from having a strong B field.

As noted above, it is contemplated that the primary laser 402 emits circularly polarised light 406 rather than linear. In this case, the phase retarder 410 will convert this circularly polarised light into linearly polarised light. It may therefore be said that the light emitted by the primary laser 402 is either circular or linear, and the light after the phase retarder 410 is the other of these two options.

It is noted that the apparatus of Fig. 4 can be implemented equally well with free space transmission of light, or as an all-fibre assembly with no free-space transmission. The all-fibre embodiment may allow for a highly compact and robust assembly.

There are several different components that can serve as the phase retarder 410. In a free-space assembly a quarter waveplate may be used (optionally an achromatic quarter waveplate for increased wavelength range), or a Fresnel rhomb. In an all-fibre assembly a strained portion of fibre may serve as the phase retarder 410, with the angle of the fibre and the applied strain chosen to achieve quarter waveplate-like behaviour.

In the all-fibre setup, portions of the optical path where the polarisation is linear may use polarisation-maintaining (PM) fibres, while portions with circular polarisation may require alternative techniques. For example, circularly polarisation can be maintained with a spun optical fibre "pig tail", meaning PM fibre that is rotated as a preform during the fibre drawing manufacturing process. This results in a fibre that can preserve circular polarisation.

It is further noted that the apparatus of Fig. 4 operates equally well regardless of whether the primary laser 402 and/or secondary laser 404 operate as pulsed lasers or CW lasers. In many quantum cryptography systems, it may be more desirable to have them operate as pulsed lasers, potentially using gain-switching. Gain-switching refers to an arrangement wherein the primary laser 402 is controlled by a control unit to produce high-speed (e.g. GHz) pulses, with each pulse having a random phase seeded by random vacuum fluctuations. In such embodiments, it is often the case that the secondary laser 404 is controlled by the same control unit.

The wider operational range of wavelengths achieved by the apparatus of Fig. 4 also makes this assembly highly suitable if the primary laser 402 and/or secondary laser 404 are tuneable lasers, meaning that their wavelength can be tuned over a range. For example, one or both of the primary laser 402 and secondary laser 404 may be external cavity diode lasers, with the cavity containing a tuneable element such as an adjustable mirror or filter. It is noted that such a tuneable laser typically varies over a considerable range of wavelengths (100 nm or more), which is too great for a Faraday isolator, but can be achieved using an achromatic quarter waveplate and/or Faraday rhomb as the phase retarder 410, as described above.

The apparatus of Fig. 4 may be included in a packaged micro-optic assembly if a highly compact assembly is desired for particular applications. It is noted that this is possible specifically because of the omission of a bulky Faraday isolator: phase retarders such as e.g. waveplates and Fresnel rhombs may be more easily miniaturised. Such a micro-optic assembly may be fibre-coupled for use in fibre-based compact optical setups.

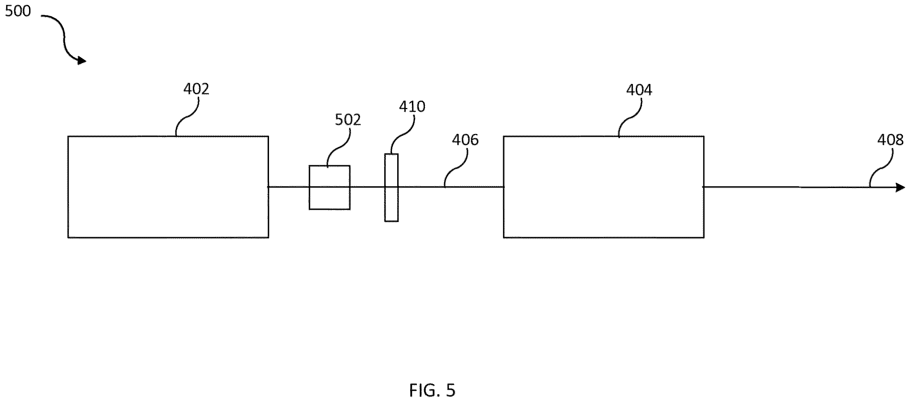

Fig. 5 shows an assembly 500 similar to the assembly 400 of Fig. 4, with the addition of a polariser 502 in between the primary laser 402 and the phase retarder 410.

It is envisaged that the polariser 502 will be configured to transmit light 406 emitted by the primary laser 402. For example, if the primary laser 402 predominantly emits horizontally polarised light, the polariser 502 may be angled to transmit horizontally polarised light.

As described above with reference to Fig. 4, back-reflected light will be converted by the phase retarder 410 to have a polarisation orthogonal to the polarisation emitted by the primary laser 402. For example, if the primary laser 402 emits horizontally polarised light, back-reflected light will be converted by the phase retarder 410 to have vertical polarisation.

Consequently, back-reflected light arriving back at the polariser 502 will be rejected (e.g. absorbed or deflected), as the polariser 502 is configured to transmit light of (in this illustrative example) horizontal polarisation, and the back-reflected light has vertical polarisation.

The polariser 502 therefore has the effect of significantly reducing (or effectively eliminating) back-reflected light reaching the primary laser 402.

As noted above, if the primary laser 402 has a fixed polarisation axis (for example, if the primary laser 402 is a semiconductor laser), light from back-reflections will not interfere with the primary laser's operation owing to the orthogonal polarisation. However, if the primary laser 402 is not such a laser, or if additional certainty is desired, the polariser 502 can be added. In particular, the polariser 502 can act to prevent not just interferometric destabilisation of the primary laser 402, but also cavity population dynamic based destabilisation.

In free space assemblies, the polariser 502 may be for example a polarising beam splitter, or additional compactness may be achieved by using e.g. a wire grid. If the apparatus is an all-fibre assembly as discussed above with regard to Fig. 4, the polariser can be implemented using a portion of polarising fibre, such as a fibre with embedded stress rods that induce extreme birefringence, resulting in a fibre that acts as a waveguide only for one polarisation.

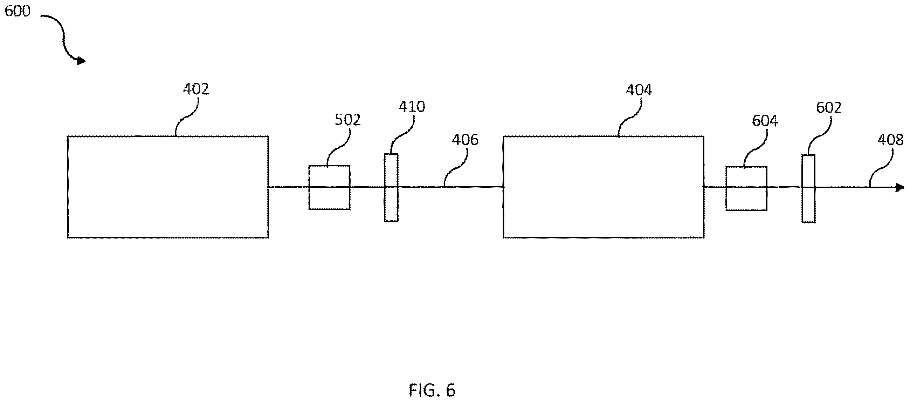

Fig. 6 shows an apparatus 600 similar to the apparatus 500 of Fig. 5, with the addition of a second polariser 604 and a second phase retarder 602 after the secondary laser 404. The second phase retarder 602 and second polariser 604 may be added to mitigate the effect of back-reflections from components after the secondary laser 404, which may otherwise destabilise the secondary laser 404. The operation of the second phase retarder 602 and second polariser 604 is exactly like the operation of the phase retarder 410 and polariser 502 described above for the primary laser 402, but instead protecting the secondary laser 404.

It is envisaged that the secondary polariser 604 will be oriented to transmit light of the dominant polarisation of the secondary laser 404, which in most optical injection locking apparatuses would be expected to be the same as the dominant polarisation of the primary laser 402.

It will be appreciated that one or both of the polarisers 502 and 604 could be omitted from the assembly 600, since (as described above) depending on the operation of the primary laser 402 and secondary laser 404, deflection of back-reflections may not be necessary.

It is additionally noted that in any of the apparatus 400, 500, or 600 there may be additional components present. For example, there may be additional components in between the primary laser 402 and secondary laser 404, such as e.g. pickoff plates for intensity monitoring, or a variable optical attenuator (VOA) to control the injection power of the secondary laser 404. For example, a VOA may be used to set the injection power to the secondary laser 404 to be 10-15 dB lower than the free-running emission power of the secondary laser 404.

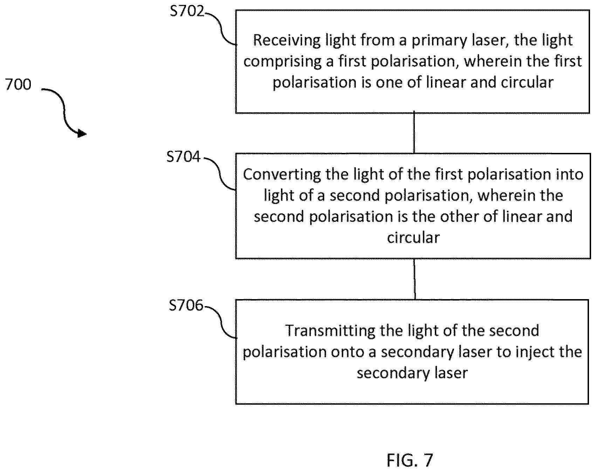

Fig. 7 illustrates the steps of a method 700 of laser injection locking.

At step S702, light of a first polarisation (linear or circular) is received from a primary laser.

At step S704, the light of the first polarisation is converted to light of a second polarisation, which is the other of linear or circular. In other words, if the received light has linear polarisation, it is converted to circular polarisation, whereas if the received light has circular polarisation, it is converted to linear polarisation. It will be appreciated that, in the illustrative example apparatuses of Figs. 4-6 as described above, this step is accomplished by the phase retarder 410.

At step S706, the light of the second polarisation is transmitted onto a secondary laser to inject the secondary laser, as part of an optical injection locking apparatus.

Based on the above discussion of Figs. 4-6 it will be appreciated that, in embodiments where an input of the secondary laser back-reflects a portion of the light of the second polarisation, this back-reflected light may then be converted to light of a third polarisation orthogonal to the first polarisation. For example, if the first polarisation is horizontal polarisation, and the second polarisation is circular polarisation, the third polarisation may be vertical polarisation. This may, for example, be accomplished by the same phase retarder that converts the first polarisation into the second polarisation (as is the case in Figs. 4-6 above).

A basic quantum communication protocol which uses polarisation will now be explained. This can be used for transmission between a transmitter and a receiver. However, it should be noted that this is not meant as limiting and other protocols could also be used. Further, the above system could be used with any QKD system and is not limited to uses with polarisation. For example, phase or energy/time based QKD protocols could also be used.

The protocol uses two bases wherein each basis is described by two orthogonal states. For this example, the bases are horizontal/vertical (H/V) and diagonal/antidiagonal D/A polarisation. However, the left circularly polarized/right circularly polarized (L/R) basis could also be selected.

The transmitter in the protocol prepares states with one of H, V, D or A polarisation. In other words, the prepared states are selected from two orthogonal states (H and V or D and A) in one of two bases H/V and D/A. This can be thought of as sending a signal of 0 and 1 in one of two bases, for example H=0, V=1 in the H/V basis and D=0, A=1 in the D/A basis. The pulses are attenuated so that they comprise on average one photon or less. Thus, if a measurement is made on the pulse, the pulse is destroyed. Also, it is not possible to split the pulse.

The receiver uses a measurement basis for the polarisation of a pulse selected from the H/V basis or the D/A basis. The selection of the measurement basis can be active or passive. In passive selection the basis is selected using fixed components, such as a beam splitter. In "active" basis choice, the receiver makes a decision of which basis to measure in - e.g. using a modulator with an electrical control signal. If the basis used to measure the pulse at the receiver is the same as the basis used to encode the pulse, then the receiver's measurement of the pulse is accurate. However, if the receiver selects the other basis to measure the pulse, then there will be a 50% error in the result measured by the receiver.

To establish a key, the sender and receiver compare the basis that were used to encoder and measure (decode). If they match, the results are kept; if they do not match the results are discarded. The above method is very secure. If an eavesdropper intercepts the pulses and measures then, the eavesdropper must prepare another pulse to send to the receiver. However, the eavesdropper will not know the correct measurement basis and will therefore only has a 50% chance of correctly measuring a pulse. Any pulse recreated by the eavesdropper will cause a larger error rate to the receiver which can be used to evidence the presence of an eavesdropper. The sender and receiver compare a small part of the key to determine the error rate and hence the presence of an eavesdropper.

Although the above has been described in relation to polarisation, this is as an illustration. Other QKD protocols could be used which are based on phase or other systems such as energy/time.

The above QKD requires two channels, a "quantum channel" which is used for the communication of pulses that contain, one average, one photon or less, and a classical channel which is used for discussion of the basis ("sifting"). Also, the classical channel can be used for further communication once the key has been established on the quantum channel. It should be noted that the term "channel" is used to refer to a logical channel. The quantum and classical channels may be provided within the same physical fibre.

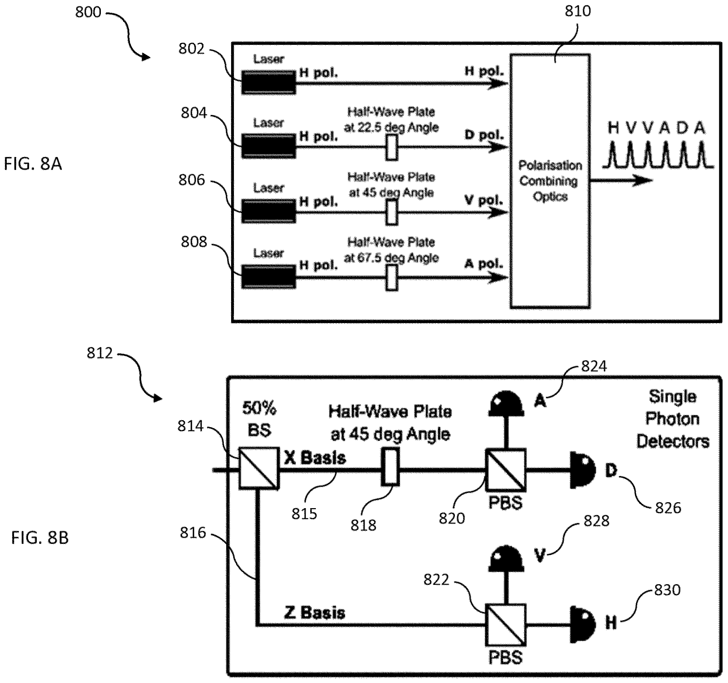

An example of a receiver and transmitter will now be described with reference to Figs. 8A and 8B.

An example of a possible transmitter is shown as 800 in FIG. 8A. The transmitter can be any type of quantum transmitter which is capable of emitting encoded photons. In this particular example, polarisation encoding will be discussed, but any type of encoding could be used, for example phase or other encoding types such as energy/time. In the example of FIG. 8A, the transmitter 800 comprises four emitters, 802, 804, 806 and 808, each of which emits horizontally polarized light. For simplicity, each emitter is shown as a single unit. However, in this embodiment, each emitter comprises the optical injection apparatus of Fig. 4. The output from emitter 802 is provided towards polarisation combining optics 810. The output from laser 804 is provided towards polarisation combining optics 810 via a half waveplate which is configured to convert the horizontally polarized light to diagonally polarized light. The output from emitter 806 is provided towards polarisation combining optics 810 via a half waveplate which is configured to convert the horizontally polarized light to vertically polarized light. The output from emitter 808 is provided towards polarisation combining optics 810 via a half waveplate which is configured to convert the horizontally polarized light to antidiagonally polarized light.

Polarisation combining optics 810 allows the different polarisations to be combined into a stream of pulses with randomly varying polarisations. This may be achieved in many different ways. For example, the lasers may be pulsed lasers and a controller (not shown) is provided to randomly select a laser from emitters 802, 804, 806 and 808 to randomly output a pulse such that one pulse at a time reaches the polarisation combining optics 810. In other embodiments, the polarisation combining optics 810 or a further component may be configured to randomly select the output from one emitter or randomly selectively block the output from three emitters to allow for the pulsed output stream. The pulses may be produced by pulses lasers, or CW lasers may be used with a further component to chop the output into pulses.

An attenuator (not shown) is then used to attenuate the output of the pulses so that they contain on average less than one photon.

The transmitter 800 of Fig. 8A comprises four emitters 802, 804, 806, 808 each of which comprise primary laser and a secondary laser in an optical injection locking arrangement. This optical injection locking is achieved using any of the setups described above with regard to Figs. 4-6 where a phase retarder is positioned between each primary laser and the respective secondary laser to mitigate back-reflections. Alternatively, the transmitter 800 may comprise one primary laser optically injecting four secondary lasers, with the arrangement of setups of Figs. 4-6 where a phase retarder is positioned between each primary laser and the respective secondary laser to mitigate back-reflections. Finally, the four emitters 802, 804, 806, 808 may be replaced with a single primary laser and an injection locked secondary laser, where the secondary laser is followed by a variable polarisation rotator in place of the waveplates shown in Fig. 8A. The use of a variable polarisation rotator tends to reduce the bit rate of the transmitter 800, as there will be a delay each time the rotator switches.

A simplified form of the receiver 812 is shown in FIG. 8B. The receiver 812 comprises a 50-50 beam splitter 814 which will direct the incoming pulse either along a first measurement channel 815 or a second measurement channel 816. Since the pulses contain on average less than one photon, the 50-50 beam splitter 814 will direct the pulse randomly along one of the first measurement channel or the second measurement channel. This has the result of selecting a measurement basis to be the X (D/A) basis or the Z (H/V) basis. The non-polarising beam splitter 814 functions to allow random selection of one of the two bases.

The first measurement channel 815 is for the X basis which corresponds to the D/A basis. Here, a half waveplate 818 is provided to rotate the polarisation by 45 degrees between the two detection branches, i.e. giving the two measurement bases X and Z. The output of the half waveplate 818 is then directed towards polarising beam splitter 820. Polarising beam splitter 820 directs pulses with antidiagonal polarisation towards antidiagonal detector 824 and pulses with diagonal polarisation towards diagonal detector 826. Detectors 824 and 826 are single photon detectors, for example avalanche photodiodes.

Pulses directed along the second measurement channel 816 are measured in the Z basis to determine if they are horizontal or vertical. Here, the pulses directed into the second measurement channel 816 are directed toward polarising beam splitter 822 which directs vertically polarised pulses towards vertical detector 828 and horizontally polarised pulses towards horizontal detector 830. Again, detectors 828 and 830 are single photon detectors.

If a photon is received which is polarised in the D/A basis and this is randomly sent to be measured in the Z basis along the second management channel 816, one of detectors 828, 830 is likely to register a count. However, this result cannot be trusted, as a photon received at polarising beam splitter 822 has a 50-50 chance of being directed towards either the vertical or the horizontal detector.

Further embodiments are set out in the following clauses:

1. A laser injection locking apparatus, the apparatus comprising:

a primary laser configured to emit light of a first polarisation;
a secondary laser configured to be injected by light from the primary laser, the secondary laser being connected to the primary laser by an optical path; and
a phase retarder provided in the optical path between the primary laser and the secondary laser, the phase retarder configured to convert light of the first polarisation to light of a second polarisation,
wherein the first polarisation is one of linear polarisation and circular polarisation, and the second polarisation is the other.

2. The apparatus of clause 1, wherein:

the secondary laser comprises an input operable to reflect a portion of the light of the second polarisation arriving at the secondary laser; and
the phase retarder is positioned such that light back-reflected along the optical path by the input passes through the phase retarder a second time and is converted to light of a third polarisation orthogonal to the first polarisation.

3. The apparatus of clause 1 or 2, wherein the first polarisation is a linear polarisation, the phase retarder comprises a quarter waveplate, and an axis of the quarter waveplate is aligned at 45° to the first polarisation.

4. The apparatus of clause 3, wherein the quarter waveplate is an achromatic quarter waveplate.

5. The apparatus of any preceding clause, wherein the phase retarder comprises a Fresnel rhomb.

6. The apparatus of any preceding clause, further comprising a polariser positioned between the primary laser and the phase retarder, the polariser configured to transmit light of the first polarisation.

7. The apparatus of any preceding clause, wherein the primary laser and the secondary laser are configured to operate as pulsed lasers.

8. The apparatus of clause 7, wherein at least one of the primary laser and the secondary laser is configured to operate using gain-switching.

9. The apparatus of any preceding clause, wherein at least one of the primary laser and the secondary laser is a tuneable laser.

10. The apparatus of any preceding clause, wherein a polarisation extinction ratio of light emitted by the primary laser is at least 20dB in favour of the first polarisation.

11. The apparatus of any preceding clause, further comprising a secondary phase retarder in the optical path after the secondary laser, wherein the secondary phase retarder is configured to convert light of the first polarisation to light of the second polarisation.

12. The apparatus of clause 11, further comprising a secondary polariser in the optical path between the secondary laser and the secondary phase retarder, wherein the secondary polariser is configured to transmit light of the first polarisation.

13. The apparatus of any preceding clause, wherein the optical path is a fibre path.

14. The apparatus of clause 13, wherein the phase retarder comprises a strained portion of optical fibre.

15. A packaged micro-optic assembly comprising the apparatus of any preceding clause.

16. A quantum cryptographic system comprising an emitter and a receiver, wherein the emitter comprises the apparatus of any preceding clause.

17. A method of laser injection locking, the method comprising:

receiving light from a primary laser, the light comprising a first polarisation;
converting the light of the first polarisation into light of a second polarisation; and
transmitting the light of the second polarisation onto a secondary laser to inject the secondary laser,
wherein the first polarisation is one of linear polarisation and circular polarisation, and the second polarisation is the other.

18. The method of clause 17, wherein the converting the light of the first polarisation into light of the second polarisation is performed using a phase retarder.

19. The method of clause 17 or 18, further comprising:

receiving back-reflected light from an input of the secondary laser;
converting the back-reflected light into light of a third polarisation, the third polarisation being orthogonal to the first polarisation; and
transmitting the light of the third polarisation onto the primary laser.

20. The method of clause 19 when dependent on clause 18, wherein the converting the back-reflected light into light of the third polarisation is performed using the phase retarder.

Whilst certain embodiments have been described, these embodiments have been presented by way of example only, and are not intended to limit the scope of the inventions. Indeed, the novel devices, and methods described herein may be embodied in a variety of other forms; furthermore, various omissions, substitutions and changes in the form of the devices, methods and products described herein may be made without departing from the spirit of the inventions. The accompanying claims are intended to cover such forms or modifications as would fall within the scope and spirit of the inventions.

## Claims

1. A laser injection locking apparatus, the apparatus comprising:

a primary laser configured to emit light of a first polarisation;
a secondary laser configured to be injected by light from the primary laser, the secondary laser being connected to the primary laser by an optical path; and
a phase retarder provided in the optical path between the primary laser and the secondary laser, the phase retarder configured to convert light of the first polarisation to light of a second polarisation,
wherein the first polarisation is one of linear polarisation and circular polarisation, and the second polarisation is the other.

2. The apparatus of claim 1, wherein:

the secondary laser comprises an input operable to reflect a portion of the light of the second polarisation arriving at the secondary laser; and
the phase retarder is positioned such that light back-reflected along the optical path by the input passes through the phase retarder a second time and is converted to light of a third polarisation orthogonal to the first polarisation.

3. The apparatus of claim 1 or 2, wherein the first polarisation is a linear polarisation, the phase retarder comprises a quarter waveplate, and an axis of the quarter waveplate is aligned at 45° to the first polarisation.

4. The apparatus of claim 3, wherein the quarter waveplate is an achromatic quarter waveplate.

5. The apparatus of any preceding claim, wherein the phase retarder comprises a Fresnel rhomb.

6. The apparatus of any preceding claim, further comprising a polariser positioned between the primary laser and the phase retarder, the polariser configured to transmit light of the first polarisation.

7. The apparatus of any preceding claim, wherein: the primary laser and the secondary laser are configured to operate as pulsed lasers; and/or
at least one of the primary laser and the secondary laser is configured to operate using gain-switching and/or at least one of the primary laser and the secondary laser is a tuneable laser.

8. The apparatus of any preceding claim, wherein a polarisation extinction ratio of light emitted by the primary laser is at least 20dB in favour of the first polarisation.

9. The apparatus of any preceding claim, further comprising a secondary phase retarder in the optical path after the secondary laser, wherein the secondary phase retarder is configured to convert light of the first polarisation to light of the second polarisation and optionally further comprising a secondary polariser in the optical path between the secondary laser and the secondary phase retarder, wherein the secondary polariser is configured to transmit light of the first polarisation.

10. A packaged micro-optic assembly comprising the apparatus of any preceding claim.

11. A quantum cryptographic system comprising an emitter and a receiver, wherein the emitter comprises the apparatus of any preceding claim.

12. A method of laser injection locking, the method comprising:

   receiving light from a primary laser, the light comprising a first polarisation;
   converting the light of the first polarisation into light of a second polarisation; and
   transmitting the light of the second polarisation onto a secondary laser to inject the secondary laser,
   wherein the first polarisation is one of linear polarisation and circular polarisation, and the second polarisation is the other.

13. The method of claim 12, wherein the converting the light of the first polarisation into light of the second polarisation is performed using a phase retarder.

14. The method of claim 12 or 13, further comprising:

   receiving back-reflected light from an input of the secondary laser;
   converting the back-reflected light into light of a third polarisation, the third polarisation being orthogonal to the first polarisation; and
   transmitting the light of the third polarisation onto the primary laser.

15. The method of claim 14 when dependent on claim 13, wherein the converting the back-reflected light into light of the third polarisation is performed using the phase retarder.

FIG. 1

FIG. 2A

FIG. 2B

FIG. 2C

FIG. 2D

EP 4 535 690 A1

FIG. 3A

FIG. 3B

EP 4 535 690 A1

EP 4 535 690 A1

400

402

410

406

404

408

FIG. 4

FIG. 5

600

402

502

410

406

404

604

602

408

FIG. 6

FIG. 7

700

S702
Receiving light from a primary laser, the light comprising a first polarisation, wherein the first polarisation is one of linear and circular

S704
Converting the light of the first polarisation into light of a second polarisation, wherein the second polarisation is the other of linear and circular

S706
Transmitting the light of the second polarisation onto a secondary laser to inject the secondary laser

EP 4 535 690 A1

FIG. 8A

FIG. 8B

Europäisches
Patentamt

European
Patent Office

Office européen
des brevets

# EUROPEAN SEARCH REPORT

Application Number

EP 24 19 4913

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 106 254 065 B (UNIV SCIENCE & TECH CHINA) 27 August 2019 (2019-08-27) | 1-5,7,8, 11-15 | INV. H04B10/70 |
| Y | * the whole document * | 4,6,9,10 | H01S5/00 H01S5/062 |
| | ----- | | H01S5/40 |
| X | US 4 455 657 A (BYER ROBERT L [US]) 19 June 1984 (1984-06-19) | 1,4,5,12 | |
| Y | * column 2 - column 3; figure 1 * | 4 | |
| | ----- | | |
| Y | US 2022/385371 A1 (WOODWARD ROBERT IAN [GB] ET AL) 1 December 2022 (2022-12-01) * paragraph [0036] - paragraph [0060]; figures 1-3A * | 1,4,7-12 | |
| | ----- | | |
| Y | RAMOS R T ET AL: "FAST HETERODYNE OPTICAL PHASE-LOCK LOOP USING DOUBLE QUANTUM WELL LASER DIODES", ELECTRONICS LETTERS, THE INSTITUTION OF ENGINEERING AND TECHNOLOGY, GB, vol. 28, no. 1, 1 January 1992 (1992-01-01), pages 82-83, XP000278947, ISSN: 0013-5194 * page 1; figure 1 * | 1,4,7-12 | |
| | ----- | | **TECHNICAL FIELDS SEARCHED (IPC)** |
| Y | TSERMAA BAATARCHULUUN ET AL: "Construction of a Broad-Band Optical Isolator by Using an Achromatic Circular Polarizer", JOURNAL OF HTE KOREAN PHYSICAL SOCIETY, vol. 48, no. 5, 2 May 2006 (2006-05-02), pages 892-896, XP093245886, * page 892 - page 893; figure 1 * | 1,4,6-12 | H01S H04B |
| | ----- | | |

The present search report has been drawn up for all claims

| Place of search | Date of completion of the search | Examiner |
|---|---|---|
| Munich | 3 February 2025 | Hervé, Denis |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 19 4913

This annex lists the patent family members relating to the patent documents cited in the above-mentioned European search report.
The members are as contained in the European Patent Office EDP file on
The European Patent Office is in no way liable for these particulars which are merely given for the purpose of information.

03-02-2025

| Patent document cited in search report | | Publication date | Patent family member(s) | | Publication date |
|---|---|---|---|---|---|
| CN 106254065 | B | 27-08-2019 | NONE | | |
| US 4455657 | A | 19-06-1984 | NONE | | |
| US 2022385371 | A1 | 01-12-2022 | EP | 4096119 A1 | 30-11-2022 |
| | | | GB | 2607105 A | 30-11-2022 |
| | | | JP | 7362816 B2 | 17-10-2023 |
| | | | JP | 2022182993 A | 08-12-2022 |
| | | | US | 2022385371 A1 | 01-12-2022 |

EPO FORM P0459

For more details about this annex : see Official Journal of the European Patent Office, No. 12/82